# EUROPÄISCHE PATENTSCHRIFT

(11) **EP 1 589 130 B1**
(45) Veröffentlichungstag und Bekanntmachung des Hinweises auf die Patenterteilung: **29.07.2009**
(21) Anmeldenummer: 04008699.3
(22) Anmeldetag: 13.04.2004
(51) Int. Cl.: C23C 14/56, B65H 23/038

(54) **Führungsanordnung mit mindestens einer Führungswalze für die Führung von Bändern in Bandbehandlungsanlagen**
Guide arrangement with at least one guide roll for guiding webs in web treating apparatuses
Dispositif de guidage avec au moins un rouleau de guidage pour guider des bandes dans un appareillage de traitement de bandes

(43) Veröffentlichungstag der Anmeldung: 26.10.2005
(73) Patentinhaber: Applied Materials GmbH & Co. KG, 63755 Alzenau (DE)
(72) Erfinder: Hein, Stefan, Dipl.-Ing., 63825 Blankenbach (DE); Skuk, Peter, Ing., 61130 Nidderau (DE); Wenk, Karl-Heinrich, Ing., 61231 Bad Nauheim (DE); Kukla, Reiner, Dipl.-Phys, 63457 Hanau (DE); Ludwig, Rainer, Dipl.-Phys, 63768 Hösbach (DE)
(74) Vertreter: Zimmermann & Partner

(56) Entgegenhaltungen:
- EP-A- 0 733 736
- JP-A- 10 297 804
- JP-A- 58 182 220
- JP-U- 01 096 207
- US-A- 4 485 125
- US-A1- 2001 040 097

## Beschreibung

Die Erfindung betrifft eine Führungsanordnung nach dem Oberbegriff des Patentanspruchs 1.

Durch den Aufsatz "Engineering Solutions Enabling a New Family of Expandable, Multi-Process, Multi-Chamber Vacuum Roll Coaters", veröffentlicht in 1999, Society of Vacuum Coaters, 42nd Annual Technical Conference Proceedings (1999) ISSN 0737-5921, Seiten 475 bis 479, ist es bekannt, eine grössere Zahl von Modulkammern und Schleusenventilen in Reihe zu schalten, um beliebige Beschichtungs- und Behandlungsverfahren von Bändern nacheinander durchführen zu können. Dies setzt jedoch eine sehr genaue lineare Ausrichtung der Modulkammern voraus, um einen störungsfreien Transport der Bänder durch alle Kammern und deren Verbindungsschlitze hindurch zu ermöglichen.

Durch die DE 197 35 603 C1 ist es bekannt, in den einzelnen, durch Bandventile getrennten Modulkammern Walzenstühle mit Führungs- und Beschichtungwalzen so anzuordnen, dass der Bandlaufweg durch Justierung bzw. Verdrehung der Walzenstühle relativ zueinander angepasst werden kann. Da hierdurch auch die Beschichtungswalzen, als Kühlwalzen bezeichnet, mit verdreht werden, ist es erforderlich, die Beschichtungsquellen, sogenannte Magnetron-Sputterquellen an die räumliche Lage der Beschichtungswalzen durch Verstellung anzupassen. Eine solche Einstellung bzw. Justierung ist umständlich, zeitaufwändig und kompliziert und setzt eine Unmenge von Justiervorrichtungen und manuelle Einstellvorgänge voraus. Nicht offenbart sind vor allem Lösungen des Problems, dass durch die Verstellung der Beschichtungswalzen auch die Spaltweiten zwischen deren Oberflächen und ortsfesten Kammer-Trennwänden verändert werden, die die Beschichtungswalzen umgeben

Durch die EP 0 733 736 A2 ist es bei einer Nicht-Vakuumanlage, z.B. bei der Papierherstellung mittels eines endlosen umlaufenden Bandes wie eines Siebbandes oder Förderbandes, bekannt, die Winkellage mindestens einer der Vielzahl von Walzen, die ein Walzenfeld bilden, durch ihren einen, auf Rollen verfahrbar geführten Lagerbock gegenüber der Laufrichtung des Bandes zu verstellen.

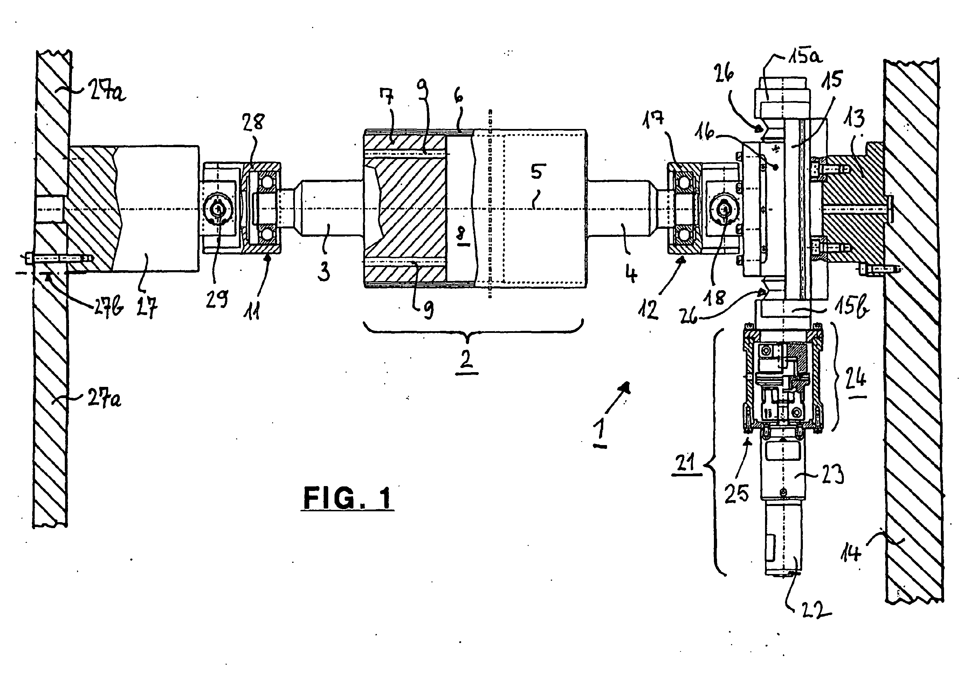

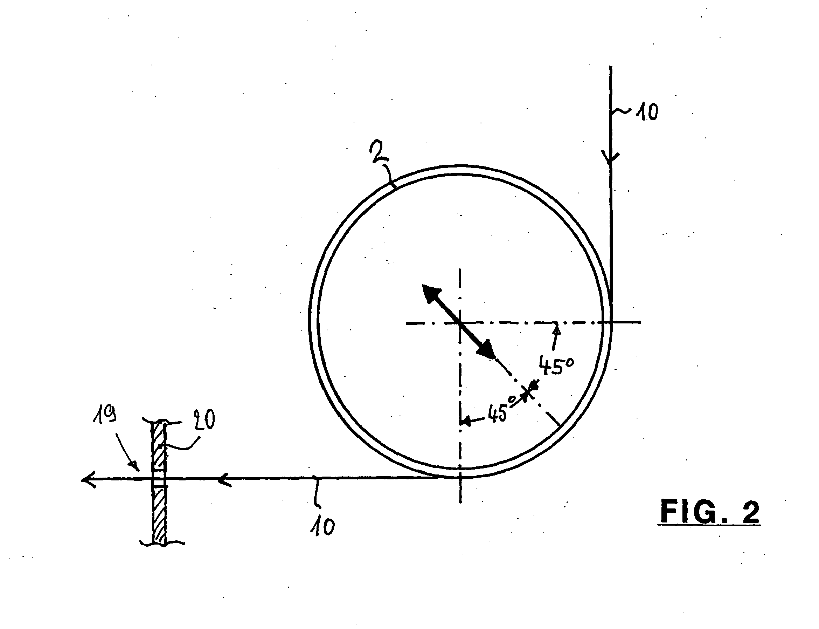

Durch die JP 1-96207 A ist eine Führungsanordnung für bandförmiges Material bekannt, die zum Ausgleich des Schängelns des Bandes eine verstellbare Ausgleichswalze besitzt. Der Vorschlag geht von einem Stand der Technik gemäss Figur 2 aus, bei dem beide Walzenenden um die Walzenmitte in einer Ebene |₁-|₁ verstellbar sind, die parallel zur Zuführebene des Bandes S verläuft. Der Vorschlag selbst gemäss Figur 1 besteht darin, eines der Walzenlager ortsfest und das andere in einer Ebene I₃-I₃ verstellbar zu machen, die mittels einer einseitigen Schlittenführung senkrecht zur Winkelhalbierenden I-I zwischen der Zufuhr- und der Abfuhrebene des Bandes S verläuft, also unter 45° zur Waagrechten. Dieser Winkel ist jedoch nicht verstellbar.

Durch die JP 10-297804 A ist es bekannt, eine mäandrierende Bewegung eines Stahlbandes dadurch zu kompensieren, dass das Stahlband nacheinander über zwei in einem Rahmen gelagerte Walzen geführt wird, von denen die in Laufrichtung vordere an ihrem einen Ende durch eine Vertikalsteuerung angehoben und abgesenkt werden kann. Die Bandführung geschieht in Form eines nach unten offenen "U" aufwärts in senkrechter Richtung zur ersten Walze, dann im wesentlich waagrecht zur zweiten Walze und dann wieder senkrecht abwärts. Zusätzlich ist der Rahmen, der einen Walzenstuhl bildet, um eine senkrechte Achse schwenkbar.

Durch die US 4,485,125 und die JP 58182220 ist es bekannt, metallische Substrate durch eine Reihe von mindestens sechs Behandlungs- und Beschichtungskammern zu ziehen, die durch Gassperren getrennt sind, um Querkontaminationen durch einen Gasaustausch zu vermeiden. Wegen des Fehlens von Kühlwalzen für eine Kontaktkühlung werden die Substrate durch die Prozessbedingungen auf Temperaturen zwischen 227 und 327°C aufgeheizt. Weiterhin hängen die Substrate unter ihrem Eigengewicht durch und folgen einer parabolischen Kurve wie dem Verlauf einer Hängebrücke, und die Kammern sind entsprechend dem Bahnverlauf vertikal abgestuft aufgestellt. Die Gassperren zwischen den Kammern sind aus dem gleichen Grunde gestuft angeordnet. Die einzige Führungseinrichtung für eine seitliche Führung der Substrate ist unmittelbar vor dem Ende der Anlage und unmittelbar unter einer Aufwickelwalze für das Substrat angeordnet, wobei es sich um eine frei laufenden Steuerwalze handelt, die ein teleskopisches Aufwickeln der Metallfolie verhindern soll. Zu diesem Zweck ist ein Ende der Steuerwalze gegenüber deren Achse verdrehbar und exzentrisch angeordnet, aber nur um wenige Tausendstel eines Inchs. Exzentrizität und Drehung sind jedoch dadurch gekoppelt und können nicht unabhängig voneinander justiert werden.

Die US 2001/0040097 A1 offenbart eine Vorrichtung, die zur galvanischen Beschichtung mit flüssigen Bädern und Wasser betrieben wird wobei zum Verhindern eines Mäanderns des band förmigen Substrats eine Führungswalze verstellbar ausgeführt ist.

Der Erfindung liegt daher die Aufgabe zugrunde, eine Führungsanordnung der eingangs beschriebenen Gattung anzugeben, bei der eine absolut lineare Ausrichtung der einzelnen Kammer-Moduln entbehrlich wird, und bei der die Bandführung unabhängig von eventuellen nicht exakt linearen Raumlagen der Beschichtungswalze und der Behandlungs- und Beschichtungsquellen und -kammermoduln eingestellt und festgelegt werden kann.

Die Lösung der gestellten Aufgabe erfolgt erfindungsgemäss durch die Merkmale im Kennzeichen des Patentanspruchs 1.

Durch die Erfindung werden die Nachteile des Standes der Technik vermieden, insbesondere wird eine Führungsanordnung der eingangs beschriebenen Gattung angegeben, bei der eine absolut lineare Ausrichtung der einzelnen Kammer-Moduln entbehrlich wird, und bei der die Bandführung unabhängig von von eventuellen nicht exakt linearen Raumlagen der Beschichtungswalze und/oder der Behandlungs- und Beschichtungsquellen und -kammermoduln einstellbar und festlegbar ohne grossen konstruktiven und bedienungsseitigen Aufwand durchführbar ist.

Es ist dabei besonders vorteilhaft, wenn im Zuge weiterer Ausgestaltungen der Erfindung - entweder einzeln oder in Kombination - :
* die verstellbaren Führungswalzen jeweils vor einem Schlitz als Durchtrittsöffnung zur nachfolgenden Kammer angeordnet sind,
* die verstellbaren Führungswalzen jeweils hinter einem Schlitz als Durchtrittsöffnung zur nachfolgenden Kammer angeordnet sind,
* das verstellbare Drehlager eine Schlittenführung aufweist, an der ein Schlitten mit dem Drehlager geführt ist,
* das verstellbare Drehlager an einer Kammerwand angeordnet ist,
* das verstellbare Drehlager parallel zur Kammerwand verstellbar ist,
* das verstellbare Drehlager schwenkbar am Schlitten gehalten ist,
* die Verstellrichtung des Drehlagers in der Winkelhalbierenden des Umschlingungswinkels der Führungswalze durch das Band liegt,
* das verstellbare Drehlager einen ferngesteuerten Verstellantrieb aufweist,
* der Verstellantrieb aus einem Elektromotor, einem Untersetzungsgetriebe und einer Rotationskupplung besteht,
* die Rotationskupplung ein elastisches Zwischenglied aufweist,
* der Elektromotor, das Untersetzungsgetriebe und die Rotationskupplung miteinander fluchtende Achsen aufweisen,
* die fluchtenden Achsen parallel zur Verschieberichtung der Schlittenführung ausgerichtet sind,
* der nicht vom Schlitten abgedeckte Teil der Schlittenführung von mindestens einem Faltenbalg abgedeckt ist,
* die Schlittenführung beidendig je einen Anschlag aufweist,
* das nicht in Querrichtung verstellbare Drehlager am anderen Ende der Führungswalze schwenkbar an einer Haltevorrichtung befestigt ist,
* die Haltevorrichtung des nicht verstellbaren Drehlagers ein Axialspiel für den Ausgleich von Winkel- und Längenänderungen der Führungswalze besitzt,
* im Bereich mindestens einer Kante des durchlaufenden Bandes mindestens ein optischer Sensor für die Erfassung des Laufweges dieser Kante und die Beeinflussung des Verstellantriebes angeordnet ist.
* auf dem Bandlaufweg auf einer Linie senkrecht zur Bandkante mehrere optische Sensoren für die Bestimmung des momentanen Bandlaufweges angeordnet sind,
* die Abweichung der Bandlaufrichtung von der Geraden auf den Walzenanordnungen der nicht exakt zueinander ausgerichteten benachbarten Kammermoduln mit wenigestens einer verstellbaren Führungswalze in wenigstens einem Kammermodul ausgleichbar ist, und/oder, wenn
* die Ausrichtung der Bandlaufrichtung in den Kammern einer aus einzelnen Kammermoduln zusammengesetzten Bandbehandlungsanlage bei Abweichung der Bandlaufrichtung von der Geraden auf den Walzenanordnungen der nicht exakt zueinander ausgerichteten benachbarten Kammermoduln in mindestens einem dieser Kammermoduln durch mindestens eine verstellbare Führungswalze einstellbar ist, und/oder, wenn
* die, Führungsanordnung mit mindestestens einer Führungswalze, die eine Achse aufweist und zwischen zwei Drehlagern gelagert ist, von denen mindestens eines relativ zum ändern mittels einer Schlittenführung mit einem Schlitten quer zur Achse verstellbar an einer Kammerwand angeordnet ist, zum Ausgleich von Abweichungen der Laufrichtung von Bändern in mindestens einer Kammer von aus einzelnen, nicht exakt zueinander ausgerichteten Kammermoduln zusammengesetzten evakuierbaren Bandbehandlungsanlage verwendet wird.

Ausführungsbeispiele des Erfindungsgegenstandes und deren Wirkungsweisen werden nachfolgend anhand der Figuren 1 bis 3 näher erläutert.

Es zeigen:
- Figur 1: eine teilweise geschnittene Ansicht einer Führungsanordnung mit radialer Blickrichtung zur Achse der Führungswalze,
- Figur 2: einen Radialschnitt durch eine Führungswalze mit einem darüber geführten Band und
- Figur 3: eine perspektivische Ansicht von zwei aneinander gereihten Kammermoduln von Behandlungs- oder Beschichtungsanlagen.

In Figur 1 ist eine Führungsanordnung 1 mit einer Führungswalze 2, gezeigt, von der jedoch nur die beiden Enden mit ihren Lagerzapfen 3 und 4 gezeigt sind und die eine Achse 5, einen hierzu konzentrischen Mantel 6 und zwei Endstücke 7 aufweist. Der Innenraum 8 steht über Entlüftungs-und Belüftungsbohrungen 9 mit der Umgebung, d.h. dem Kammervolumen in Verbindung.

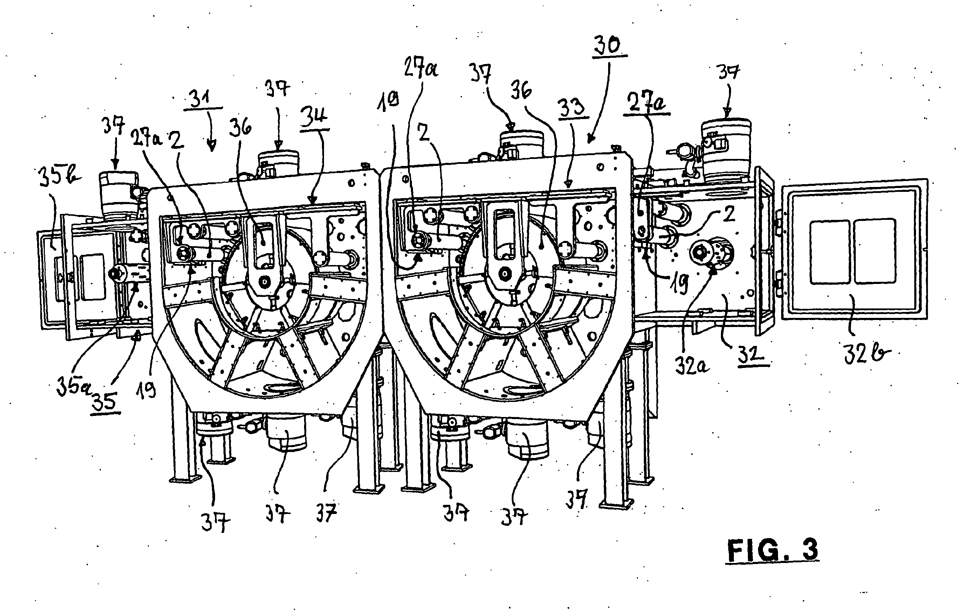

Die Führungswalze 2 dient zur Führung von Bändern 10 (siehe Figur 2) in evakuierbaren Bandbehandlungsanlagen gemäss Figur 3. Die Raumlage der Achse 5 ist dadurch einstellbar, dass die Führungswalze 2 zwischen zwei Drehlagern 11 und 12 gelagert ist, von denen das rechte relativ zum linken quer zur Achse 5 verstellbar ist. Das verstellbare Drehlager 12 ist mittels einer Haltevorrichtung 13 an einer Kammerwand 14 befestigt und parallel zu dieser verstellbar.

Dies geschieht dadurch, dass das verstellbare Drehlager 12 eine an der Kammerwand 14 befestigte Schlittenführung 15 aufweist, an der ein Schlitten 16 mit dem Drehlager 12 geführt ist. Dieses ist über ein Lagergehäuse 17 mittels eines Schwenklagers 18 schwenkbar am Schlitten 16 gehalten.

Gemäß Figur 2 liegt die Verstellrichtung (Doppelpfeil) der Schlittenführung 15 in der Winkelhalbierenden des Umschlingungswinkels von beispielsweise 90 Grad der Führungswalze 2 durch das Band 10. Hierdurch kann durch einen minimalen Verstellweg eine maximale Veränderung der Bandlaufrichtung quer zum Band 10 erreicht werden, so dass dieses ohne Berührung mit dem Rand eines Schlitzes 19 in einer Trennwand 20 zwischen zwei Kammervolumina hindurchgeführt und von der Bandführung im nachfolgenden Kammervolumen übernommen werden kann.

Grundsätzlich ist jedoch eine Verstellung in beliebige Raumlagen möglich, und es kann auch auf eine Verstellung verzichtet werden, wenn der Bandlaufweg bereits den Vorgaben entspricht. Der Fachmann kann durch Abweichungen von der Winkelhalbierenden zwischen maximaler Verstellwirkung und maximaler Verstellgenauigkeit wählen.

Das verstellbare Drehlager 12 weist einen ferngesteuerten Verstellantrieb 21 auf, der aus einem Elektromotor 22, einem Untersetzungsgetriebe 23 und einer Rotationskupplung 24 besteht, die in einem tragenden, be- und entlüftbaren Gehäuse 25 untergebracht ist. Die Rotationskupplung 24 besitzt ein nicht beziffertes elastisches Zwischenglied. Der Elektromotor 22, das Untersetzungsgetriebe 23 und die Rotationskupplung 24 weisen miteinander fluchtende Achsen auf, die parallel zur Verschieberichtung der Schlittenführung 15 ausgerichtet sind. Dabei ist der nicht vom Schlitten 16 abgedeckte Teil der Schlittenführung 15 von mindestens einem Faltenbalg 26 abgedeckt. Die Schlittenführung 15 besitzt beidendig je einen Anschlag 15a und 15b.

Die Ausrichtung der Führungswalze 2 bzw. des durchlaufenden Bandes 10 kann dadurch automatisiert werden, dass die Lage der Kante des Bandes 10 über einen nicht gezeigten optischen Sensor detektiert wird, der über ein Stellglied, z.B. den Verstellantrieb 21, die Führungswalze entsprechend ausrichtet. Auch können mehrere optische Sensoren auf einer Linie senkrecht zur Bandkante eingesetzt werden, durch die die momentane Lage des Bandes 10 erfasst wird.

Das nicht in Querrichtung zur Achse 5 verstellbare linke Drehlager 11 am anderen Ende der Führungswalze 2 ist schwenkbar an einer ortsfesten Haltevorrichtung 27 befestigt, und zwar über ein Lagergehäuse 28 und ein weiteres Schwenklager 29. Die Anordnung ist dabei so getroffen, dass die Haltevorrichtung 27 des nicht verstellbaren Drehlagers 11 ein Axialspiel für den Ausgleich von Winkel- und Längenänderungen der Führungswalze 2 besitzt. Die Aufhängung 27a kann dabei aus einer Kammerwand oder aus einer an der Kammerdecke aufgehängten Lasche bestehen. In dem zuletzt genannten und in Figur 3 gezeigten Fall endet die Aufhängung an der strichpunktierten Begrenzungslinie 27b.

Die Figur 3 zeigt eine perspektivische Ansicht von zwei aneinander gereihten Kammermoduln 30 und 31 von Behandlungs- oder Beschichtungsanlagen, die aus einer Reihenanordnung von evakuierbaren Kammern 32, 33, 34 und 35 bestehen, in denen die verstellbaren Führungswalzen 2 jeweils vor einer Durchtrittsöffnung in Form eines Schlitzes 19 zur nachfolgenden Kammer angeordnet sind, wie dies in Figur 2 angedeutet ist.

Die Kammer 32 ist eine Einschleuskammer mit einem drehbaren Aufnahmedorn 32a für einen hier nicht gezeigten unbehandelten Bandwickel und einer Verschlussklappe 32b. Die Kammermoduln 30 und 31 sind ähnlich aufgebaut. Ihre gleichfalls evakuierbaren Kammern 33 und 34 besitzen etwa in ihrem Zentrum je eine gekühlte Beschichtungswalze 36 auf deren Umfang jeweils vier nicht bezifferte radiale Trennwände angeordnet sind, deren innere Enden bis auf enge Spalte an das jeweils eingelegte Band 10 heranreichen.

Oberhalb der beiden obersten Trennwände befindet sich eine gemeinsame Teilkammer für alle Führungs- und Umlenkwalzen, unterhalb der genannten Trennwände befinden sich drei sektorförmige Teilkammern für den Einschub von hier nicht gezeigten Behandlungs- und/oder Beschichtungsquellen, die an einer hier gleichfalls nicht gezeigten wegfahrbaren Verschlussplatte befestigt sind. Alle Teilkammern sind an eigene Vakuumpumpen 37 angeschlossen.

Die Kammer 35 ist eine Ausschleuskammer mit einem drehbaren Aufnahmedorn 35a für einen hier nicht gezeigten behandelten Bandwickel und einer Verschlussklappe 35b. Die vorderen Verschlusswände der Kammern 32 und 35 sind wegen der Einblicksmöglichkeit gleichfalls weggelassen.

Die Führungswalzen 2 sind nicht angetrieben, sondern werden von dem jeweils einlegten Band "geschleppt". Sie müssen auch keine zylindrische Oberfläche besitzen, sondern können auch als Breitstreckwalzen in Bananenform oder mit kegelförmigen Walzenabschnitten ausgeführt sein, deren Mantellinien eine gemeinsame, fluchtende und lineare Abzugslinie durchlaufen. Auch ist die Zahl der Kammermoduln 30 und 31 ist nahezu beliebig.

Weder die Beschichtungswalze noch die Behandlungs- und Beschichtungsquellen, noch die Trennwände zwischen den Teilkammern müssen bei einer Justierung der Führungswalze deren Bewegung nachgestellt werden, im Gegensatz z.B. zur DE 197 35 603 C1

### Bezugszeichenliste:

- 1: Führungsanordnung
- 2: Führungswalze
- 3: Lagerzapfen
- 4: Lagerzapfen
- 5: Achse
- 6: Mantel
- 7: Endstücke
- 8: Innenraum
- 9: Entlüftungs- und Belüftungsbohrungen
- 10: Band
- 11: Drehlager
- 12: Drehlager
- 13: Haltevorrichtung
- 14: Kammerwand
- 15: Schlittenführung
- 15a: Anschlag
- 15b: Anschlag
- 16: Schlitten
- 17: Lagergehäuse
- 18: Schwenklager
- 19: Schlitz
- 20: Trennwand
- 21: Verstellantrieb
- 22: Elektromotor
- 23: Untersetzungsgetriebe
- 24: Rotationskupplung
- 25: Gehäuse
- 26: Faltenbalg
- 27: Haltevorrichtung
- 27a: Aufhängevorrichtung
- 27b: Begrenzungslinie
- 28: Lagergehäuse
- 29: Schwenklager
- 30: Kammermodul
- 31: Kammermodul
- 32: Kammer
- 32a: Aufnahmedorn
- 32b: Verschlussklappe
- 33: Kammer
- 34: Kammer
- 35: Kammer
- 35a: Aufnahmedorn
- 35b: Verschlussklappe
- 36: Beschichtungswalze
- 37: Vakuumpumpen

## Patentansprüche

1. Führungsanordnung (1) zum Ausrichten der Laufrichtung eines Bandes (10) in Kammern (32, 33, 34, 35) einer aus einzelnen, evakuierbaren Kammermoduln (30, 31) zusammengesetzten Bandbehandlungsanlage mit mindestens einer zwischen Drehlagern (11, 12) gelagerten Führungswalze (2) für eine Bandführung, wobei
a) in den Kammermoduln (30. 31) Beschichtungswalzen (36) angeordnet sind, und wobei
b) die Kammern (32, 33, 34, 35) durch spaltförmig Schlitze (19) miteinander In Verbindung stehen,
**dadurch gekennzeichnet, dass** mindestens eines der Drehlager (11, 12) relativ zum anderen quer zur Achse (5) derart verstellbar ist, dass das Band (10) ohne Berührung mit dem Rand des jeweils benachbarten Schlitzes (19) durch diesen hindurch führbar ist.

2. Führungsanordnung nach Anspruch 1, **dadurch gekennzeichnet, dass** die verstellbaren Führungswalzen (2) jeweils vor einem Schlitz (19) als Durchtrittsöffnung zur nachfolgenden Kammer angeordnet sind.

3. Führungsanordnung nach Anspruch 1, **dadurch gekennzeichnet, dass** die verstellbaren Führungswalzen (2) jeweils hinter einem Schlitz (19) als Durchtrittsöffnung zur nachfolgenden Kammer angeordnet sind.

4. Führungsanordnung nach Anspruch 1, **dadurch gekennzeichnet, dass** das verstellbare Drehlager (12) eine Schlittenführung (15) aufweist, an der ein Schlitten (16) mit dem Drehlager (12) geführt ist.

5. Führungsanordnung nach Anspruch 1, **dadurch gekennzeichnet, dass** das verstellbare Drehlager (12) an einer Kammerwand (14) angeordnet ist.

6. Führungsanordnung nach Anspruch 5, **dadurch gekennzeichnet, dass** das verstellbare Drehlager (12) parallel zur Kammerwand (14) verstellbar ist.

7. Führungsanordnung nach Anspruch 4, **dadurch gekennzeichnet, dass** die Schlittenführung (15) an einer Kammerwand befestigt ist,

8. Führungsanordnung nach Anspruch 4, **dadurch gekennzeichnet, dass** das verstellbare Drehlager (12) schwenkbar am Schlitten (16) gehalten ist.

9. Führungsanordnung nach Anspruch 1, **dadurch gekennzeichnet, dass** die Verstellrichtung des Drehlagers (12) in der Winkelhalbierenden des Ümschlingungswinkels der Führungswalze (2) durch das Band (10) liegt,

10. Führungsanordnung nach Anspruch 1, **dadurch gekennzeichnet, dass** das verstellbare Drehlagers (12) einen ferngesteuerten Verstellantrieb (21) aufweist.

11. Führungsanordnung nach Anspruch 10, **dadurch gekennzeichnet, dass** der Verstellantrieb (21) aus einem Elektromotor (22), einem Untersetzungsgetriebe (23) und einer Rotationskupplung (24) besteht.

12. Führungsanordnung nach Anspruch 11, **dadurch gekennzeichnet, dass** die Rotationskupplung (24) ein elastisches Zwischenglied aufweist.

13. Führungsanordnung nach Anspruch 10, **dadurch gekennzeichnet, dass** der Elektromotor (22), das Untersetzungsgetriebe (23) und die Rotationskupplung (24) miteinander fluchtende Achsen aufweisen.

14. Führungsanordnung nach Anspruch 13, **dadurch gekennzeichnet, dass** die fluchtenden Achsen parallel zur Verschieberichtung der Schlittenführung (15) ausgerichtet sind.

15. Führungsanordnung nach Anspruch 4, **dadurch gekennzeichnet, dass** der nicht vom Schlitten (16) abgedeckte Teil der Schlittenführung (15) von mindestens einem Faltenbalg (26) abgedeckt ist.

16. Führungsanordnung nach Anspruch 4, **dadurch gekennzeichnet, dass** die Schlittenführung (15) beidendig je einen Anschlag (15a, 18b) aufweist.

17. Führungsanordnung nach Anspruch 1, **dadurch gekennzeichnet, dass** das nicht in Querrichtung verstellbare Drehlager (11) am anderen Ende der Führungswalze (2) schwenkbar an einer Haltevorrichtung (27) befestigt ist.

18. Führungsanordnung nach Anspruch 17, **dadurch gekennzeichnet, dass** die Haltevorrichtung (27) des nicht verstellbaren Drehlagers (11) ein Axialspiel für den Ausgleich von Winkel- und Längenänderungen der Führungswalze (2) besitzt.

19. Führungsanordnung nach Anspruch 1, **dadurch gekennzeichnet, dass** im Bereich mindestens einer Kante des durchlaufenden Bandes (10) mindestens ein optischer Sensor für die Erfassung des Laufweges dieser Kante und die Beeinflussung des Verstellantriebes (21) angeordnet ist.

20. Führungsanordnung nach Anspruch 19, **dadurch gekennzeichnet, dass** auf dem Bandlaufweg auf einer Linie senkrecht zur Bandkante mehrere optische Sensoren für die Bestimmung des momentanen Bandlaufweges angeordnet sind.

21. Verwendung einer Führungsanordnung (1) mit mindestens einer Führungswalze (2), die eine Achse (5) aufweist und zwischen zwei Drehlagern (11,12) gelagert ist, von denen mindestens eines relativ zum anderen mittels einer Schlittenführung (15) mit einem Schlitten (16) quer zur Achse (5) verstellbar an einer Kammerwand (14) angeordnet ist, zum Ausgleich von Abweichungen der Laufrichtung von Bändern (19) in mindestens einer Kammer von aus einzelnen, nicht exakt zueinander ausgerichteten Kammermoduln (30, 31) zusammengesetzten evakuierbaren Bandbehandlungsanlage.

## Claims

1. Guiding device (1) for aligning the direction of movement of a strip (10) in chambers (32, 33, 34, 35) of a strip treatment system composed of several chamber modules (30, 31), which can be evacuated, with at least one guiding roller (2) for a strip guidance mounted between swivels (11, 12), wherein
a) coating rollers (36) are disposed in the chamber modules (30, 31), and wherein
b) the chambers (32, 33, 34, 35) are connected with each other through slit-shaped slots (19),
**characterized in that** at least one of the swivels (11, 12) is adjustable relative to the other one cross the axis (5) such that the strip (10) can be without touching the edge of the in each case adjacent slot (19) fed through said slot.

2. Guiding device according to claim 1, **characterized in that** the adjustable guiding rollers (2) are each disposed in front of one slot (19) as opening to the subsequent chamber.

3. Guiding device according to claim 1, **characterized in that** the adjustable guiding rollers (2) are each disposed behind one slot (19) as opening to the subsequent chamber.

4. Guiding device according to claim 1, **characterized in that** the adjustable swivel (12) has a carriage guide (15), at which a carriage (16) with the swivel (12) is guided.

5. Guiding device according to claim 1, **characterized in that** the adjustable swivel (12) is disposed at a chamber wall (14).

6. Guiding device according to claim 5, **characterized in that** the adjustable swivel (12) is adjustable parallel to the chamber wall (14).

7. Guiding device according to claim 4, **characterized in that** the carriage guide (15) is attached to a chamber wall.

8. Guiding device according to claim 4, **characterized in that** the adjustable swivel (12) is retained pivotably at the carriage (16).

9. Guiding device according to claim 1, **characterized in that** the direction of adjustment of the swivel (12) lies in the bisecting line of the strip's (10) entangle angle around the guiding roller (2).

10. Guiding device according to claim 1, **characterized in that** the adjustable swivel (12) has a remote-controlled adjustment actuation (21).

11. Guiding device according to claim 10, **characterized in that** the adjustment actuation (21) consists of an electromotor (22), a reduction gear unit (23) and a rotational coupling (24).

12. Guiding device according to claim 11, **characterized in that** the rotational coupling (24) has an elastic connecting link.

13. Guiding device according to claim 10, **characterized in that** the electromotor (22), the reduction gear unit (23) and the rotational coupling (24) have axes that are aligned with each other.

14. Guiding device according to claim 13, **characterized in that** the aligned axes are aligned parallel to the adjustment direction of the carriage guide (15).

15. Guiding device according to claim 4, **characterized in that** the part of the carriage guide (15), which is not covered by the carriage (16), is covered by at least one rubber gaiter (26).

16. Guiding device according to claim 4, **characterized in that** the carriage guide (15) has one end stop (15a, 15b) at each end, respectively.

17. Guiding device according to claim 1, **characterized in that** the swivel (11), which is not adjustable in cross direction, is pivotably attached at the other end of the guiding roller (2) to a holding device (27).

18. Guiding device according to claim 17, **characterized in that** the holding device (27) of the non-adjustable swivel (11) has an axial play for the compensation between angle- and length-change of the guiding roller (2).

19. Guiding device according to claim 1, **characterized in that** at least one optic sensor is disposed in the region of at least one edge of the traversing strip (10) for the detection of the route of said edge and for the influence of the adjustment actuator (21).

20. Guiding device according to claim 19, **characterized in that** multiple optical sensors for the determination of the current strip route are disposed in the strip route in a line perpendicular to the strip edge.

21. Use of a guiding device (1) with at least one guiding roller (2), which has an axis (5) and which is mounted between two swivels (11, 12), of which at least one is disposed adjustably in relation to the other cross to the axis (5) by means of one carriage guide (15) with a carriage (16) at a chamber wall (14), for the compensation of deviations of the route of strips (19) in at least one chamber of a strip treatment system, which can be evacuated, composed of several chamber modules (30, 31), which are not precisely aligned to each other.

## Revendications

1. Dispositif de guidage (1) permettant d'orienter le sens de marche d'une bande (10) dans des chambres (32, 33, 34, 35) d'un appareillage de traitement de bandes composé de différents modules de chambres évacuables (30, 31), comportant au moins un rouleau de guidage (2), destiné au guidage de bande, logé entre des coussinets de pivotement (11, 12), dans lequel
a) dans les modules de chambre (30, 31) sont disposés des rouleaux d'enduction (36), et dans lequel
b) les chambres (32, 33, 34, 35) sont en relation par des rainures en forme de fente (19),
**caractérisé en ce qu'**au moins un des coussinets de pivotement (11, 12) est réglable par rapport à l'autre perpendiculairement à l'axe (5) de façon à ce que la bande (10) puisse être guidée à travers l'appareillage sans toucher le bord de chaque rainure (19) voisine respective.

2. Dispositif de guidage selon la revendication 1, **caractérisé en ce que** les rouleaux de guidage réglables (2) sont disposés respectivement devant une rainure (19) en tant qu'ouverture de passage vers la chambre suivante.

3. Dispositif de guidage selon la revendication 1, **caractérisé en ce que** les rouleaux de guidage réglables (2) sont disposés respectivement derrière une rainure (19) en tant qu'ouverture de passage vers la chambre suivante.

4. Dispositif de guidage selon la revendication 1, **caractérisé en ce que** le coussinet de pivotement (12) présente une glissière de chariot (15) au niveau de laquelle un chariot (16) est guidé avec le coussinet de pivotement (12).

5. Dispositif de guidage selon la revendication 1, **caractérisé en ce que** le coussinet de pivotement réglable (12) est disposé au niveau d'une paroi de chambre (14).

6. Dispositif de guidage selon la revendication 5, **caractérisé en ce que** le coussinet de pivotement réglable (12) est réglable parallèlement à la paroi de chambre (14).

7. Dispositif de guidage selon la revendication 4, **caractérisé en ce que** la glissière de chariot (15) est fixée au niveau d'une paroi de chambre.

8. Dispositif de guidage selon la revendication 4, **caractérisé en ce que** le coussinet de pivotement réglable (12) est maintenu au niveau du chariot (16) de façon orientable.

9. Dispositif de guidage selon la revendication 1, **caractérisé en ce que** le sens de réglage du coussinet de pivotement (12) repose dans la bissectrice de l'angle d'enroulement du rouleau de guidage (2) par la bande (10).

10. Dispositif de guidage selon la revendication 1, **caractérisé en ce que** le coussinet de pivotement (12) présente un entraînement de réglage (21) télécommandé.

11. Dispositif de guidage selon la revendication 10, **caractérisé en ce que** l'entraînement de réglage (21) se compose d'un moteur électrique (22), d'un réducteur (23) et d'un coupleur rotatif (24).

12. Dispositif de guidage selon la revendication 11, **caractérisé en ce que** le coupleur rotatif (24) présente une butée élastique.

13. Dispositif de guidage selon la revendication 10, **caractérisé en ce que** le moteur électrique (22), le réducteur (23) et le coupleur rotatif (24) présentent des axes alignés les uns avec les autres.

14. Dispositif de guidage selon la revendication 13, **caractérisé en ce que** les axes alignés sont orientés parallèlement au sens de déplacement de la glissière de chariot (15).

15. Dispositif de guidage selon la revendication 4, **caractérisé en ce que** la partie de la glissière de chariot (15) non recouverte par le chariot (16) est recouverte d'au moins un soufflet de protection (26).

16. Dispositif de guidage selon la revendication 4, **caractérisé en ce que** la glissière de chariot (15) présente respectivement à chaque extrémité une butée (15a, 15b).

17. Dispositif de guidage selon la revendication 1, **caractérisé en ce que** le coussinet de pivotement (11) non réglable dans le sens transversal est fixé à un dispositif de retenue (27) de façon orientable au niveau de l'autre extrémité du rouleau de guidage (2).

18. Dispositif de guidage selon la revendication 17, **caractérisé en ce que** le dispositif de retenue (27) du coussinet de pivotement non réglable (11) possède un jeu axial pour compenser les modifications d'angles et de longueurs du rouleau de guidage (2).

19. Dispositif de guidage selon la revendication 1, **caractérisé en ce que** dans la zone d'au moins une arête de la bande (10) qui passe est disposé au moins un détecteur optique destiné à enregistrer le parcours de cette arête et l'influence de l'entraînement de réglage (21).

20. Dispositif de guidage selon la revendication 19, **caractérisé en ce que** sur le parcours de la bande sont disposés, sur une ligne perpendiculaire à l'arête de bande, plusieurs capteurs optiques destinés à déterminer la trajectoire instantanée de la bande.

21. Utilisation d'un dispositif de guidage (1) comportant au moins un rouleau de guidage (2) qui présente un axe (5) et est logé entre deux coussinets de pivotement (11, 12), parmi lesquels au moins un est disposé au niveau d'une paroi de chambre (14) de façon réglable par rapport à l'autre au moyen d'une glissière de chariot (15) équipée d'un chariot (16) transversal à l'axe (5), afin de compenser les écarts au sens de marche des bandes (19) dans au moins une chambre d'un appareillage de traitement de bande évacuable composé de modules de chambre (30, 31) séparés et non orientés exactement les uns par rapport aux autres.
